# EUROPÄISCHE PATENTSCHRIFT

(11) **EP 0 218 920 B1**
(45) Veröffentlichungstag und Bekanntmachung des Hinweises auf die Patenterteilung: **19.01.1994**
(21) Anmeldenummer: 86112547.4
(22) Anmeldetag: 10.09.1986
(51) Int. Cl.: H01J 49/44, H01J 37/00, H01J 37/05

(54) **Elektronenenergiefilter vom Omega-Typ**
Omega-type electron energy filter
Filtre d'énergie électronique de type Oméga

(30) Priorität: 13.09.1985 DE 3532699
(43) Veröffentlichungstag der Anmeldung: 22.04.1987
(73) Patentinhaber: Firma Carl Zeiss, D-73446 Oberkochen (DE)
(72) Erfinder: Rose, Harald, Prof. Dr., D-6100 Darmstadt (DE); Lanio, Stefan, D-6101 Rossdorf 2 (DE)

(56) Entgegenhaltungen:
- DE-A- 2 031 811
- DE-B- 1 195 517
- GB-A- 2 098 797
- US-A- 4 412 131

## Beschreibung

Die vorliegende Erfindung betrifft ein abbildendes magnetisches Elektronenenergiefilter vom Omega-Typ, vorzugsweise für Elektronenmikroskope, mit vier Umlenkwinkeln in Magnetfeldern, mit geraden Polschuhkanten sowie mit einer in einer Ebene Verlaufenden Mittelachse des Elektronenstrahls und einer zu dieser Ebene senkrecht stehenden Symmetrieebene.

Abbildende Elektronenenergiefilter, auch Elektronenfilter, Energiefilter oder Elektronen(energie)spektrometer genannt, werden bei Transmissions-Elektronenmikroskopen verwendet, um den Kontrast der Objektabbildung durch die Auswahl von Elektronen eines bestimmten Energiebereiches zu verbessern. Das ist am deutlichsten erkennbar bei nicht kontrastierten, sehr dünnen Präparaten mit einem gewählten Energieverlust (Δ E) im Bereich von ca. 100 bis 200 eV. Aber auch ein Objektbild, das durch rein elastisch gestreute Elektronen (Energieverlust Δ E=0) entsteht, indem alle unelastisch gestreuten Elektronen (Δ E>0) ausgeblendet werden, ist im Kontrast gegenüber dem ungefilterten Bild deutlich verbessert.

Ein weiterer wesentlicher Vorteil eines Transmissions-Elektronenmikroskopes mit einem abbildenden Elektronenfilter besteht in der Möglichkeit element-spezifische Objektabbildungen, d.h. Element-Verteilungsbilder, gleichzeitig von einem relativ großen Objektbereich dadurch durchzuführen, daß der vom Elektronenfilter durchgelassene Energiebereich einer element-spezifischen Wechselwirkung der transmittierten Elektronen mit dem Objekt entspricht, also z.B. einer K-, L-, M-Absorption in der Atomhülle. Damit können qualitative und bei Messung der Intensitätsverhältnisse und Abzug des Untergrundes auch quantitative Verteilungsbilder von Elementen in dünnen Objekten (≦30 nm) mit sehr hoher Ortsauflösung (≈0,5 nm) und höchster Nachweisempfindlichkeit (≈2.10⁻²¹g) gewonnen werden, die bisher mit keiner anderen Analysentechnik erreicht wurden. Höchste Ortsauflösung und Nachweisempfindlichkeit von Elementen sind sowohl für die biologische und medizinische Forschung als auch für die Material-Wissenschaft von großer Bedeutung.

Auch bei Elektronenbeugungsdiagrammen bewirkt ein abbildendes Elektronenfilter durch die Ausblendung von unelastisch gestreuten Elektronen schärfere Bilder des Beugungsdiagrammes. Außerdem können Beugungsdiagramme von unelastisch gestreuten Elektronen eines bestimmten Energiebereiches aufgenommen werden.

Aus der DE-A- 20 28 357 ist ein Elektronenmikroskop bekannt, das eine Filterung des Objektbildes oder des Beugungsdiagrammbildes ermöglicht. Dabei wird ein Elektronenfilter verwendet, das aus einem magnetischen Prisma und einem elektrostatischen Spiegel besteht. Letzterer ist jedoch sehr empfindlich gegenüber äußeren Störfeldern; außerdem treten bei hohen Beschleunigungsspannungen für die Elektronen Isolationsprobleme auf. Daher werden in neuerer Zeit rein magnetische Filter bevorzugt. Bei diesen Energiefiltern unterscheidet man nach dem Verlauf der Elektronenbahnen sog. Alpha- und Omega-Filter.

Omega-Filter sind aus verschiedenen Veröffentlichungen bekannt. G. Zanchi e.a. (Optik 43, 495 (1975)) beschreiben eine Anordnung, die aus drei Magneten und drei Umlenkbereichen mit Umlenkwinkeln von 116°, 232° und 116° besteht. Mit vier Umlenkbereichen und Umlenkwinkeln von 90° oder kleiner sind mehrere Veröffentlichungen bekannt (H. Rose e.a. Optik 40, 336 (1974), D. Krahl e.a. Ninth International Congress on Electron Microscopy, Toronto, 1, 42 (1978), H. Wollnik e.a. Optik 46, 255 (1976)).

Ein abbildendes Elektronenfilter muß, damit es in einem Elektronenmikroskop optimal verwendet werden kann, folgende zwei Bedingungen erfüllen: Eine große Anzahl von Bildpunkten muß ohne Verlust an Ortsauflösung übertragen werden und die Bildfehler in der Ausgangsquellebene (auch als Selektionsebene bezeichnet) müssen so gering sein, daß kleine Energiebreiten (der durchgelassenen Elektronen) realisiert werden können.

Bei den aus den oben angeführten Veröffentlichungen bekannten Elektronenfiltern sind in allen Fällen die erreichbaren Energiebreiten nicht befriedigend; in vielen Fällen ist auch die Ortsauflösung ungenügend.

Aus einer Veröffentlichung von H. Rose e.a. (Optik 54, 235 (1979)) ist eine Anordnung bekannt, die ebenfalls aus vier Umlenkbereichen mit Umlenkwinkeln von 90° besteht. Durch gekrümmte Kanten der Polschuhe und drei zusätzliche Hexapole wird eine praktisch vollständige Korrektur der Bildfehler erreicht. Nachteilig bei dieser Anordnung ist jedoch der große Aufwand für die Herstellung, insbesondere für die gekrümmten Kanten. Außerdem ist dieses Elektronenfilter durch die gekrümmten Kanten schlecht justierbar.

Der vorliegenden Erfindung liegt daher die Aufgabe zugrunde, ein Omega-Filter mit geraden Kanten der Polschuhe zu schaffen, das eine gute Ortsauflösung hat, kleine Energiebreiten ermöglicht und mit einer möglichst geringen Anzahl von Hexapolen auskommt.

Die gestellte Aufgabe wird erfindungsgemäß durch ein Omega-Filter mit den Merkmalen des Anspruchs 1 gelöst.

In einer vorteilhaften Ausführung liegen die Umlenkwinkel in dem im abhängigen Anspruch 3 angegebenen Wertebereich.

Das Energiefilter ist aus vier Umlenkbereichen zur Beeinflußung des Elektronenstrahles aufgebaut. Für diesen Fall gibt der Anspruch 4 vorteilhafte Wertebereiche für die Winkel zwischen den Polschuhkanten und den Wellenfronten des Elektronenstrahles an.

In einer besonders vorteilhaften Ausführungsform werden die Randfelder, welche außerhalb der Kanten der Polschuhe entstehen, durch Abschirmplatten (in der Literatur teilweise auch als mirror plates oder field clamps bezeichnet) wesentlich verkleinert. Diese Abschirmplatten sind mindestens an den Stellen, wo der Elektronenstrahl in die Umlenkbereiche ein- und austritt, in einem geringen Abstand von den Polschuhkanten und vorzugsweise in gleicher Höhe wie die Polschuhoberflächen angeordnet. In einer weiteren vorteilhaften Ausführungsform bilden die Abschirmplatten mit den Polschuhen ein gemeinsames Teil z.B. aus Weicheisen, wobei die Spulen zur Erzeugung des Magnetfeldes in einen in sich geschlossenen Kanal eingelegt sind, der die Polschuhoberflächen von den umgebenden Abschirmflächen trennt. Diese Technik zur Herstellung von homogenen Magnetfeldern mit kleinen und definierten Randfeldern ist aus einer Arbeit von A.V. Crewe e.a. (Rev. Sci. Instr. 42, 411 (1971)) bekannt.

In einer anderen vorteilhaften Ausführung ist zur Beeinflußung des Elektronenstrahls zwischen dem zweiten und dem dritten Umlenkbereich ein Hexapol als zusätzliches Mittel zur Korrektur der Bildfehler angeordnet. Für diesen Fall gibt der Anspruch 9 vorteilhafte Wertebereiche für die Winkel zwischen den Polschuhkanten und den Wellenfronten des Elektronenstrahles an. Auch in diesem Fall werden in einer besonders vorteilhaften Ausführungsform Abschirmplatten benutzt, welche mit den Polschuhen ein gemeinsames Teil bilden können.

Sowohl bei der Ausführung ohne Hexapol als auch bei der Ausführung mit Hexapol liegt in der Mittelebene des Filters ein stigmatisches Bild der Eingangsbildebene. Außerdem erfolgt bei beiden Ausführungen eine achromatische und stigmatische Abbildung der Eingangsbildebene in die Ausgangsbildebene im Maßstab 1:1, sowie eine dispersive und stigmatische Abbildung der Eingangsquellebene in die Ausgangsquellebene.

Ein wesentlicher Vorteil der Energiefilter mit Abschirmplatten besteht darin, daß sie leicht zu justieren sind und daß Störfelder gut abgeschirmt werden.

Die Erfindung wird im folgenden anhand von in den Figuren 1 bis 3b dargestellten Ausführungsbeispielen näher erläutert. Dabei zeigen
- Fig. 1: ein Omega-Filter ohne Hexapol;
- Fig. 2: ein Omega-Filter mit Hexapol;
- Fig. 3a: einen Schnitt durch ein Ablenksystem aus zwei Polschuhen mit integrierten Abschirmplatten und
- Fig. 3b: eine Draufsicht auf einen Polschuh mit integrierten Abschirmplatten.

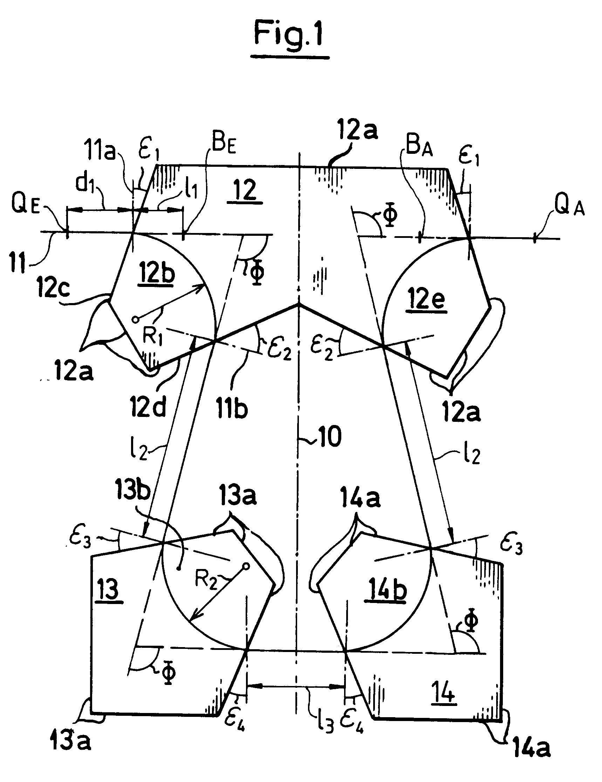

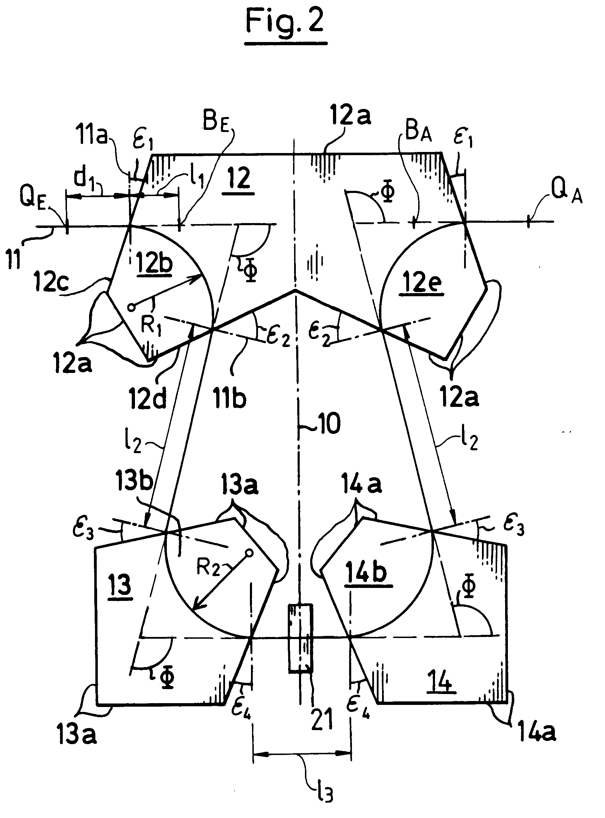

In den Figuren 1 und 2 ist die Zeichenebene diejenige Ebene in welcher die Mittelachse 11 des Elektronenstrahles durch das Filter läuft. Wie alle anderen bekannten Omega-Filter sind auch diese Filter symmetrisch zur Mittelebene aufgebaut, welche senkrecht auf der Zeichenebene steht und diese in der Linie 10 schneidet. In dieser Symmetrieebene liegt ein Zwischenbild der (virtuellen) Eingangsbildebene B_{E}, welche von Omega-Filter in die (virtuelle) Ausgangsbildebene B_{A} abgebildet wird.

Die in den Figuren 1 und 2 dargestellten Filter bestehen aus Magneten, von denen die unter der Zeichenebene liegenden Polschuhe 12, 13 und 14 mit ihren Kanten 12a, 13a und 14a dargestellt sind. Zwischen den unter- und oberhalb der Zeichenebene liegenden Polschuhen, welche spiegelbildlich gleich zur Zeichenebene ausgebildet sind, bestehen homogene Magnetfelder, welche den Elektronenstrahl in den Umlenkbereichen 12b, 13b, 14b und 12e auf Kreisbahnen mit den Umlenkradien R₁ und R₂ um den Winkel φ ablenken, wobei die exakten Radien und Winkel von der Energie der Elektronen abhängen, wodurch in der Ausgangsquellebene Q_{A} ein Energiespektrum entsteht, von dem Bereiche ausgeblendet werden können.

Beim Eintritt des Elektronenstrahles 11 in den ersten Umlenkbereich 12b bildet die Kante 12c des Polschuhes 12 (und entsprechend die nicht gezeichnete Kante des zur Zeichenebene spiegelbildlich angeordneten zweiten Polschuhes für das Magnetfeld) mit der Richtung 11a der Wellenfront des Elektronenstrahles 11 den Winkel ε₁. Zwischen der Richtung 11b der Wellenfront des aus dem Umlenkbereich 12b austretenden Elektronenstrahles 11 und der Kante 12d des Polschuhes 12 besteht der Winkel ε₂. Entsprechende Winkel ε₃ und ε₄ gelten beim Ein- und Austritt in den zweiten Umlenkbereich 13b.

Im weiteren Verlauf bestehen infolge des symmetrischen Aufbaues des Filters die entsprechenden Winkel, wie in Figur 1 angegeben. Durch geeignete Wahl dieser zwischen den Wellenfronten und Polschuhkanten bestehenden Winkel läßt sich eine Fokussierung des Elektronenstrahles auch in der zur Zeichenebene senkrechten Ebene ereichen. Für eine gute Korrektur der Abbildungsfehler haben sich für die in Figur 1 dargestellte Anordnung als besonders vorteilhaft folgende Bereiche herausgestellt:
100° ≦ φ ≦ 115°
25° ≦ ε₁ ≦ 40°
30° ≦ ε₂ ≦ 45°
15° ≦ ε₃ ≦ 30°
10° ≦ ε₄ ≦ 35°
0,8 ≦ R₂/R₁ ≦ 1,6
Die weiteren geometrischen Abmessungen des Energiefilters d₁, l₁, l₂, l₃ und R₂ / R₁ ergeben sich dann zwangsläufig aus der Forderung einer mindestens annähernd stigmatischen Abbildung der (virtuellen) Eingangsbildebene B_{E} in die (virtuelle) Ausgangsbildebene B_{A} und der Eingangsquellebene Q_{E} in die Ausgangsquellebene Q_{A}.

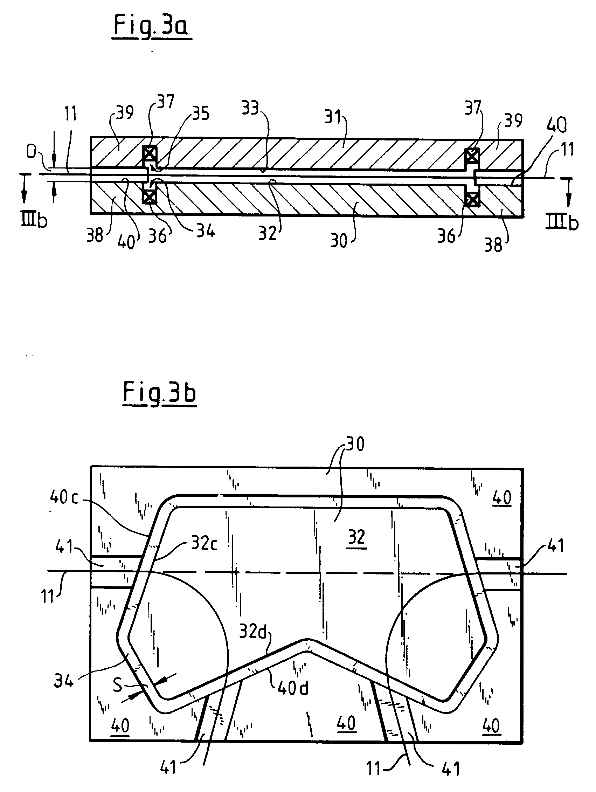

Die in der Figur 1 dargestellten Polschuhe 12, 13 und 14 haben sehr ausgedehnte Randfelder, welche den Elektronenstrahl 11 auch außerhalb der Umlenkbereiche 12b. 13b, 14b und 12e beeinflussen. Diese Randfelder lassen sich durch Abschirmplatten wesentlich verkleinern. In den Figuren 3a und 3b ist eine besonders vorteilhafte Ausführungsform hierfür dargestellt, bei welcher der in Figur 1 mit 12 bezeichnete Polschuh 32 ein gemeinsames Teil 30 mit den Abschirmplatten bildet. Das Teil 30 kann ebenso wie das zum Ablenksystem gehörende zweite Teil 31 z.B. aus Weicheisen sein. In die Teile 30 und 31 sind Nuten 34 und 35 mit der Breite S eingearbeitet, deren innere Kontur die Form der Polschuhe 32 und 33 z.B. mit den Kanten 32c und 32d bildet. Die äußere Kontur der Nuten 34 und 35 bildet z.B. die Kanten 40c und 40d der Abschirmplatte 38. Ein durch die in den Nuten 34 und 35 liegenden Spulen 36 und 37 fließender Strom erzeugt zwischen den Polschuhen 32 und 33 ein homogenes magnetisches Feld. Außerhalb der Nuten 34 und 35 entsteht dagegen kein magnetisches Feld, so daß das Randfeld im wesentlichen auf die Breite S der Nuten beschränkt ist. Zweckmäßigerweise ist der Abstand D der Abschirmplatten 38 und 39 an den Stellen 41, wo der Elektronenstrahl 11 durchläuft, ebenso groß wie der Abstand der Polschuhoberflächen 32 und 33. Das muß jedoch nicht der Fall sein. An den übrigen Stellen 40 liegen die Abschirmplatten 38 und 39 unmittelbar aufeinander.

Die größte Anzahl von Bildpunkten, die ohne Verlust an Ortsauflösung übertragen werden, und die geringsten Fehler in der Ausgangsquellebene Q_{A}, so daß kleine Energiebreiten erreichbar sind, werden durch die in den Ansprüchen 6 und 7 angegebenen Werte erreicht. Dabei sind die geometrischen Abmessungen des Filters so normiert, daß durch geeignete Wahl von R₁ die Summe der Abstände d₁ + l₁ dem Abstand zwischen Quellebene und Bildebene angepaßt werden kann, der vom Abbildungssystem eines beliebigen Elektronenmikroskops vorgegeben ist.

In Figur 2 ist ein im Aufbau ähnliches Omega-Filter dargestellt, das sich von dem in Figur 1 gezeigten Filter durch eine etwas andere Dimensionierung und durch einen Hexapol 21 unterscheidet. (Da der Aufbau des übrigen Filters ähnlich ist, wurden die gleichen Bezugszeichen wie in Figur 1 verwendet.) Durch den in der Elektronenoptik bekannten Hexapol (einem magnetischen System mit sechs Polschuhen, die radial zur Achse des Elektronenstrahles angeordnet sind) ist eine noch etwas bessere Korrektur der Abbildungsfehler in der Ausgangsquellebene Q_{A} möglich, so daß mit der in Figur 2 dargestellten Anordnung eine Verbesserung der Energieauflösung um den Faktor 1,6 gegenüber der mit der in Figur 1 dargestellten Anordnung erreicht wird. Bei gängigen Elektronenmikroskopen mit einem Endbildradius von 50 mm sind damit Energiebreiten ΔE bis zu 2,1 eV gegenüber 3,3 ev möglich.

Es ist selbstverständlich, daß im Strahlengang noch weitere Hexapole angeordnet werden können, mit denen jedoch, wenn das Omega-Filter richtig dimensioniert ist, die Abbildungseigenschaften nicht mehr verbessert werden.

Für das in Figur 2 dargestellte Energiefilter haben sich als vorteilhaft folgende Bereiche herausgestellt
100° ≦ φ ≦ 115°
100 ≦ ε₁ ≦ 30°
25° ≦ ε₂ ≦ 45°
10° ≦ ε₃ ≦ 30°
15° ≦ ε₄ ≦ 35°
0,8 ≦ R₂/R₁ ≦ 1,6
Auch bei dieser Ausführungsform ist es besonders vorteilhaft die Ausdehnung der Randfelder durch Abschirmplatten - wie z.B. in den Figuren 3a und 3b dargestellt - zu verkleinern. Die besten Abbildungseigenschaften werden durch die im Anspruch 11 angegebenen Werte erreicht. Selbstverständlich ist auch in diesem Fall durch geeignete Wahl von R₁ eine Anpassung an jedes beliebige Elektronenmikroskop möglich.

## Patentansprüche

1. Abbildendes magnetisches Elektronenenergiefilter vom Omega-Typ, vorzugsweise für Elektronenmikroskope, mit vier Umlenkbereichen in Magnetfeldern mit geraden Polschuhkanten sowie mit einer in einer Ebene verlaufenden Mittelachse des Elektronenstrahls und einer zu dieser Ebene senkrecht stehenden Symmetrieebene, dadurch gekennzeichnet, daß die Umlenkwinkel (φ) in den Umlenkbereichen (12b, 13b, 14b, 12e) größer oder gleich 100° sind und daß beim Austritt aus dein zweiten Umlenkbereich (13b) zwischen der Richtung der Wellenfront des Elektronenstrahls und der Kante (13a) des zweiten Polschuhs (13) ein Winkel (ε₄) besteht, der größer oder gleich 10° ist.

2. Elektronenenergiefilter nach Anspruch 1, dadurch gekennzeichnet, daß in der Symmetrieebene ein stigmatisches Zwischenbild einer Eingangsbildebene (B_{E}) liegt, welches vom Elektronenenergiefilter in eine Ausgangsbildebene (B_{A}) abgebildet ist.

3. Elektronenenergiefilter nach Anspruch 1 oder 2, dadurch gekennzeichnet, daß die Mittelachse des Elektronenstrahls (11) innerhalb der Umlenkbereiche (12b, 13b, 14b, 12e) auf Kreisbahnen mit Umlenkradien (R₁, R₂) um Umlenkwinkel (φ) abgelenkt ist, wobei die Umlenkradien (R₁, R₂) in einem Verhältnis von 0,8 ≦ R₂/R₁ ≦ 1,6 zueinander stehen und die Umlenkwinkel (φ) in einem Wertebereich 100° ≦ φ ≦ 115° liegen.

4. Elektronenenergiefilter nach einem der Ansprüche 1 bis 3, dadurch gekennzeichnet, daß beim Eintritt des Elektronenstrahls (11) in den ersten Umlenkbereich (12b) eine Kante (12c) des ersten Polschuhs (12) einen Winkel (ε₁), beim Austritt des Elektronenstrahls aus dem ersten Umlenkbereich (12b) eine Kante (12d) des Polschuhs (12) einen Winkel (ε₂) und beim Eintritt in den zweiten Umlenkbereich (13) eine Kante (13a) des zweiten Polschuhs (13) einen Winkel (ε₃) mit der Richtung (11a, 11b) der Wellenfront des Elektronenstrahls bilden, daß die Winkel (ε₁, ε₂, ε₃, ε₄) innerhalb der Wertebereiche
25° ≦ ε₁ ≦ 40°
30° ≦ ε₂ ≦ 45°
15° ≦ ε₃ ≦ 30°
10° ≦ ε₄ ≦ 35°
liegen und dadurch, daß die geometrischen Abmessungen (d₁, l₁, l₂, l₃, R₂/R₁) so gewählt sind, daß in der Ausgangsbildebene (B_{A}) eine mindestens annähernd stigmatische Abbildung der Eingangsbildebene (B_{E}) und in der Ausgangsquellebene (Q_{A}) eine mindestens annähernd stigmatische Abbildung der Eingangsquellebene (Q_{E}) erfüllt ist.

5. Elektronenenergiefilter nach Anspruch 4, dadurch gekennzeichnet, daß vor dem ersten Umlenkbereich (12b), zwischen den Umlenkbereichen (12b, 13b, 14b, 12e) und nach dem letzten Umlenkbereich (12e) Abschirmplatten (38, 39) angeordnet sind, deren Oberflächen mindestens annähernd in der Höhe der Oberflächen der Polschuhe (32, 33) liegen und deren Kanten (40c, 40d) im geringen Abstand (S) parallel zu den Kanten (32c, 32d) der Polschuhe angeordnet sind.

6. Elektronenenergiefilter nach Anspruch 5, gekennzeichnet durch folgende Werte für die Umlenkwinkel (φ), die Winkel (ε₁, ε₂, ε₃, ε₄) zwischen der Richtung der Wellenfront und den Polschuhkanten (12c, 12d, 13a) und dem Verhältnis (R₂/R₁) der Umlenkradien (R₁, R₂)
φ = 108°
ε₁ = 32,0°
ε₂ = 38,0°
ε₃ = 24,5°
ε₄ = 24,1°
R₂/R₁ = 1.

7. Elektronenenergiefilter nach Anspruch 6,
gekennzeichnet durch folgende geometrische Abmessungen für den Abstand (d₁) zwischen der Eingangsquellebene und der Eintrittskante des ersten Umlenkbereichs (12h), die Abstände (l₂, l₃) zwischen den Umlenkbereichen, den Abstand (D) zwischen den Abschirmplatten (38, 39) im Bereich des Elektronenstrahls (11) und den Abstand (S) zwischen den Kanten (40c, 40d) der Abschirmplatten und den Kanten (32c, 32d) der Polschuhe:
d₁ = 1,00 R₁
l₁ = 0,66 R₁
l₂ = 2,52 R₁
l₃ = 0,79 R₁
S = 0,10 R₁
D = 0,10 R₁
wobei R₁ so gewählt ist, daß die Summe d₁ + l₁ gleich dem Abstand des vom Abbildungssystem des Elektronenmikroskops vorgegebenen Abstandes zwischen der Quellebene (Q_{E}) und der Bildebene (B_{E}) ist.

8. Elektronenenergiefilter nach Anspruch 3, dadurch gekennzeichnet, daß zwischen dem zweiten Umlenkbereich (13b) und dem dritten Umlenkbereich (14b) ein Hexapol (21) angeordnet ist.

9. Elektronenenergiefilter nach Anspruch 8, dadurch gekennzeichnet, daß beim Eintritt des Elektronenstrahls (11) in den ersten Umlenkbereich (12b) eine Kante (12c) des ersten Polschuhs (12) einen Winkel (ε₁), beim Austritt des Elektronenstrahls aus dem ersten Umlenkbereich eine Kante (12d) des Polschuhs (12) einen Winkel (ε₂) und beim Eintritt in den zweiten Umlenkbereich (13b) eine Kante (13a) des zweiten Polschuhs (13) einen Winkel (ε₃) mit der Richtung (11a, 11b) der Wellenfront des Elektronenstrahls bilden, daß die Winkel (ε₁, ε₂, ε₃, ε₄) innerhalb der Wertebereiche
10° ≦ ε₁ ≦ 30°
25° ≦ ε₂ ≦ 45°
10° ≦ ε₃ ≦ 30°
15° ≦ ε₄ ≦ 35°
liegen und daß die geometrischen Abmessungen (d₁, l₁, l₂, l₃, R₂/R₁) so gewählt sind, daß in der Ausgangsbildebene (B_{A}) eine mindestens annähernd stigmatische Abbildung der Eingangsbildebene (B_{E}) und in der Ausgangsquellebene (Q_{A}) eine mindestens annähernd stigmatische Abbildung der Eingangsquellebene (Q_{E}) erfüllt ist.

10. Elektronenenergiefilter nach Anspruch 9, dadurch gekennzeichnet, daß vor dem ersten Umlenkbereich (12b), zwischen den Umlenkbereichen (12b, 13b, 14b, 12e) und nach dem letzten Umlenkbereich (12e) Abschirmplatten (38, 39) angeordnet sind, deren Oberflächen mindestens annähernd in der Höhe der Oberflächen der Polschuhe (32, 33) liegen und deren Kanten (40c, 40d) im geringen Abstand (S) parallel zu den Kanten (32c, 32d) der Polschuhe angeordnet sind.

11. Elektronenenergiefilter nach Anspruch 10, gekennzeichnet durch folgende Werte für die Umlenkwinkel (φ), die Winkel (ε₁, ε₂, ε₃, ε₄) zwischen der Richtung der Wellenfront und den Polschuhkanten (12c, 12d, 13a) und dem Verhältnis (R₂/R₁) der Umlenkradien (R₁, R₂)
φ = 104°
ε₁ = 18,0°
ε₂ = 39,0°
ε₃ = 27,5°
ε₄ = 30,1°
R₂/R₁ = 1
und durch folgende geometrische Abmessungen für den Abstand (d₁) der Eingangsquellebene von der Eintrittskante des ersten Umlenkbereichs (12b), die Abstände (l₂, l₃) zwischen den Umlenkbereichen, den Abstand (D) zwischen den Abschirmplatten (38, 39) im Bereich des Elektronenstrahls (11) und den Abstand (S) zwischen den Kanten (40c, 40d) der Abschirmplatten und den Kanten (32c, 32d) der Polschuhe:
d₁ = 1,03 R₁
l₁ = 0,92 R₁
l₂ = 2,43 R₁
l₃ = 1,34 R₁
S = 0,14 R₁
D = 0,14 R₁
wobei R₁ so gewählt wird, daß die Summe d₁ + l₁ gleich dem Abstand zwischen Quellebene und Bildebene ist, der vom Abbildungssystem des Elektronenmikroskops vorgegeben ist.

## Claims

1. An imaging magnetic electron-energy filter of the omega-type, preferably for an electron microscope, with four deflecting regions within magnetic fields having straight pole shoe edges, with a center axis of the electron beam running in a plane and with a symmetry plane perpendicular to this plane, characterized by the fact that the deflection angles (Φ) in the deflecting regions (12b, 13b, 14b, 12e) are larger than or equal to 100° and that at the exit of the second deflecting region (13b) an angle (ε₄) is formed between the direction of the wave front of the electron beam and the edge (13a) of the second pole shoe (13) which angle is larger than or equal to 10°.

2. Electron-energy filter according to claim 1, characterized by the fact that a stigmatic intermediate image of an entry image plane (B_{E}) is lieing in the symmetry plane, which intermediate image is imaged into an exit image plane (B_{A}) by the electron energy filter.

3. Electron-energy filter according to claim 1 or 2, characterized by the fact that the center axis of the electron beam (11) is deflected in the deflecting regions (12b, 13b, 14b, 12e) along orbital curves having deflection radii (R₁, R₂) and along deflection angles (Φ), whereby the deflection radii have a ratio with respect to each other lieing in the range of 0,8 ≦ R₂/R₁ ≦ 1,6 and the deflection angles (Φ) are lieing in the value range 100° ≦ Φ ≦ 115°.

4. Electron-energy filter according to one of the claims 1-3, characterized by the fact that at the entrance of the electron beam (11) into the first deflecting region (12b) an edge (12c) of the first pole shoe (12) formes an angle (ε₁), at the exit of the electron beam of the first deflecting region (12b) an edge (12d) of the pole shoe (12) formes an angle (ε₂) and at the entrance into the second deflecting region (13) an edge (13a) of the second pole shoe (13) formes an angle (ε₃) with respect to the direction (11a, 11b) of the wave front of the electron beam, that the angles (ε₁, ε₂, ε₃, ε₄) are lieing in the value ranges
25° ≦ ε₁ ≦ 40°
30° ≦ ε₂ ≦ 45°
15° ≦ ε₃ ≧ 30°
10° ≦ ε₄ ≦ 35°
and that the geometric dimensions (d₁, l₁, l₂, l₃, R₂/R₁) are selected so as to cause at least an approximate stigmatic imaging of the entry image plane (B_{E}) into the exit image plane (B_{A}) and so as to cause at least an approximate stigmatic imaging of the entry source plane (Q_{E}) into the exit source plane (Q_{A}).

5. Electron-energy filter according to claim 4, characterized by the fact that shielding plates (38, 39) are arranged ahead of the first deflecting region (12b), between the deflecting regions (12b, 13b, 14b, 12e) and after the last deflecting region (12e), which shielding plates have a surface lieing at least approximately at the elevation of the surfaces of the pole shoes (32, 33) and which have edges (40c, 40d) arranged at a narrow spacing (S) parallel to the edges (32c, 32d) of the pole shoes.

6. Electron-energy filter according to claim 5, characterized by the following values for the deflection angles (Φ), the angles (ε₁, ε₂, ε₃, ε₄) between the direction of the wave front and the edges (12c, 12d, 13a) of the pole shoes and the ratio (R₂/R₁) of the deflection radii (R₁, R₂)
Φ = 108°
ε₁ = 32.0°
ε₂ = 38.0°
ε₃ = 24.5°
ε₄ = 24.1°
R₂/R₁ = 1.

7. Electron-energy filter according to claims 6,
characterized by the following geometric dimensions of the distance (d₁) between the entrance source plane and the entry edge of the first deflecting region (12b), the distances (l₂, l₃) between the deflecting regions, the distance (D) between the shielding plates (38, 39) in the region of the electron beam (11) and the spacing (S) between the edges (40c, 40d) of the shielding plates and the edges (32c, 32d) of the pole shoes:
d₁ = 1.00 R₁
l₁ = 0.66 R₁
l₂ = 2.52 R₁
l₃ = 0.79 R₁
S = 0.10 R₁
D = 0.10 R₁
whereby R₁ is selected so that the sum d₁ + l₁ is equal to the distance between the source plane (Q_{E}) and the image plane (B_{E}) as pregiven by the imaging system of the electron microscope.

8. Electron-energy filter according to claim 3, characterized by the fact, that an hexapole (21) is arranged between the second deflecting region (13b) and the third deflecting region (14b).

9. Electron-energy filter according to claim 8, characterized by the fact, that at the entrance of the electron beam (11) into the first deflecting region (12b) an edge (12c) of the first pole shoe (12) forms an angle (ε₁), at the exit of the electron beam of the first deflecting region (12b) an edge (12d) of the pole shoe (12) form an angle (ε₂) and at the entrance into the second deflecting region (13) an edge (13a) of the second pole shoe (13) forms an angle (ε₃) with respect to the direction (11a, 11b) of the wave front of the electron beam, that the angles (ε₁, ε₂, ε₃, ε₄) are lieing in the value ranges
10° ≦ ε₁ ≦ 30°
25° ≦ ε₂ ≦ 45°
10° ≦ ε₃ ≦ 30°
15° ≦ ε₄ ≦ 35°
and that the geometric dimensions (d₁, l₁, l₂, l₃, R₂/R₁) are selected so as to cause at least an approximate stigmatic imaging of the entry image plane (B_{E}) into the exit image plane (B_{A}) and so as to cause at least an approximate stigmatic imaging of the entry source plane (Q_{E}) into the exit source plane (Q_{A}).

10. Electron-energy filter according to claim 9, characterized by the fact that shielding plates (38, 39) are arranged ahead of the first deflecting region (12b), between the deflecting regions (12b, 13b, 14b, 12e) and behind the last deflecting region (12e), which shielding plates have surfaces lieing at least approximately at the elevation of the surfaces of the pole shoes (32, 33) and which have edges (40c, 40d) arranged at a narrow spacing (S) parallel to the edges (32c, 32d) of the pole shoes.

11. Electron-energy filter according to claim 10, characterized by following values for the deflection angles (Φ), the angles (ε₁, ε₂, ε₃, ε₄) between the direction of the wave front and the edges (12c, 12d, 13a) of the pole shoes and the ratio (R₂/R₁) of the deflection radii (R₁, R₂)
Φ = 104°
ε₁ = 18.0°
ε₂ = 39.0°
ε₃ = 27.5°
ε₄ = 30.1°
R₂ / R₁ = 1
and by the following geometric dimensions of the distance (d₁) between the entrance source plane and the entry edge of the first deflecting region (12b), the distances (l₂, l₃) between the deflecting regions, the distance (D) between the shielding plates (38, 39) in the region of the electron beam (11) and the spacing (S) between the edges (40c, 40d) of the shielding plates and the edges (32c, 32d) of pole shoes:
d₁ = 1.03 R₁
l₁ = 0.92 R₁
l₂ = 2.43 R₁
l₃ = 1.34 R₁
S = 0.14 R₁
D = 0.14 R₁
whereby R₁ is selected so that the sum d₁ + l₁ is equal to the distance between the source plane and the image plane as pregiven by the imaging system of the electron microscope.

## Revendications

1. Filtre magnétique d'énergie électronique à reproduction de type Omega, destiné de préférence aux microscopes électroniques, offrant quatre zones de déviation par champs magnétiques et doté de pièces polaires aux bords droits et d'un axe médian de faisceau électronique situé dans un plan perpendiculaire à un plan de symétrie, caractérisé en ce que l'angle de déviation (Φ) dans les zones de déviation (12b, 13b, 14b, 12e) est supérieur ou égal à 100° et en ce que l'angle (ε₁) formé par la direction du front d'onde du faisceau électronique et par le bord (13a) de la deuxième pièce polaire (13) à la sortie de la deuxième zone de déviation (13b) est supérieur ou égal à 10°.

2. Filtre d'énergie électronique selon la revendication 1, caractérisé en ce qu'une image intermédiaire stigmatique d'un plan d'image d'entrée (B_{E}) est formée dans le plan de symétrie et reproduite dans le plan d'image de sortie (B_{A}) par le filtre d'énergie électronique.

3. Filtre d'énergie électronique selon les revendications 1 et 2, caractérisé en ce que l'axe médian du faisceau électronique (11) est dévié dans les zones de déviation (12b, 13b, 14b, 12e), le long de trajets circulaires ayant des rayons de déviation (R₁, R₂), selon des angles de déviation (Φ), les rayons de déviation (R₁, R₂) présentant un rapport compris dans la plage 0,8 ≦ R₂/R₁ ≦ 1,6 et les angles de déviation (Φ) se situant dans une plage de 100° ≦ Φ ≦ 115°.

4. Filtre d'énergie électronique selon l'une quelconque des revendications 1 à 3, caractérisé en ce que des bords (12c) et (12d) de la première pièce polaire (12) forment des angles (ε₁) et (ε₂) avec la direction (11a, 11b) du front d'ondes du faisceau électronique respectivement à l'entrée et à la sortie du faisceau électronique (11) au niveau de la première zone de déviation (12b), en ce qu'un bord (13a) de la deuxième pièce polaire (13) forme un angle (ε₃) avec la direction (11a, 11b) du front d'ondes du faisceau électronique à l'entrée dans la deuxième zone de déviation (13b), en ce que lesdits angles (ε₁, ε₂, ε₃, ε₄) situent dans les plages suivantes
25° ≦ ε₁ ≦ 40°
30° ≦ ε₂ ≦ 45°
15° ≦ ε₃ ≦ 30°
10° ≦ ε₄ ≦ 35°
et en ce que les cotes géométriques (d₁, l₁, l₂, l₃, R₂/R₁) ont été choisies de manière à assurer une reproduction au moins approximativement stigmatique du plan d'image d'entrée (B_{E}) et du plan de source d'entrée (Q_{E}) respectivement dans le plan d'image de sortie (B_{A}) et dans le plan de source de sortie (Q_{A}).

5. Filtre d'énergie électronique selon la revendication 4, caractérisé en ce que des plaques de blindage (38, 39) sont disposées avant la première zone de déviation (12b), entre les zones de déviation (12b, 13b, 14b, 12e) et après la dernière zone de déviation (12e), plaques dont les surfaces se trouvent au moins à peu près à la hauteur des surfaces des pièces polaires (32, 33) et dont les bords (40c, 40d) sont disposés à une faible distance (S) des et parallèlement aux bords (32c, 32d) des pièces polaires.

6. Filtre d'énergie électronique selon la revendication 5, caractérisé en ce que les angles de déviation (Φ), les angles (ε₁, ε₂, ε₃, ε₄) entre la direction du front d'ondes et les bords des pièces polaires (12c, 12d, 13a) et le rapport (R₁/R₂) des rayons de déviation (R₁, R₂) prennent les valeurs suivantes:
Φ = 108°
ε₁ = 32,0°
ε₂ = 38,0°
ε₃ = 24,5°
ε₄ = 24,1°
R₂/R₁ = 1

7. Filtre d'énergie électronique selon la revendication 6, caractérisé en ce que la distance (d₁) entre le plan de source d'entrée et le bord d'entrée de la première zone de déviation (12b), les distances (l₂, l₃) entre les zones de déviation, la distance (D) entre les plaques de blindage (38, 39) au niveau du faisceau électronique (11) et la distance (S) entre les bords (40c, 40d) des plaques de blindage et les bords (32c, 32d) des pièces polaires prennent les valeurs suivantes
d₁ = 1,00 R₁
l₁ = 0,66 R₁
l₂ = 2,52 R₁
l₃ = 0,79 R₁
S = 0,10 R₁
D = 0,10 R₁,
R₁ étant sélectionné de manière à ce que la somme d₁ + l₁ égale la distance séparant le plan de source (Q_{E}) du plan d'image (B_{E}), déterminée par le système de reproduction du microscope électronique.

8. Filtre d'énergie électronique selon la revendication 3, caractérisé en ce qu'un hexapôle (21) est disposé entre la deuxième zone de déviation (13b) et la troisième zone de déviation (14b).

9. Filtre d'énergie électronique selon la revendication 8, caractérisé en ce que des bords (12c) et (12d) de la première pièce polaire (12) forment des angles (ε₁) et (ε₂) avec la direction (11a, 11b) du front d'ondes du faisceau électronique respectivement à l'entrée et à la sortie du faisceau électronique (11) au niveau de la première zone de déviation (12b), en ce qu'un bord (13a) de la deuxième pièce polaire (13) forme un angle (ε₃) avec la direction (11a, 11b) du front d'ondes du faisceau électronique à l'entrée dans la deuxième zone de déviation (13), en ce que lesdits angles (ε₁, ε₂, ε₃, ε₄) se situent dans les plages suivantes
10° ≦ ε₁ ≦ 30°
25° ≦ ε₂ ≦ 45°
10° ≦ ε₃ ≦ 30°
15° ≦ ε₄ ≦ 35°
et en ce que les cotes géométriques (d₁, l₁, l₂, l₃ R₂/R₁) ont été choisies de manière à assurer une reproduction au moins approximativement stigmatique du plan d'image d'entrée (B_{E}) et du plan de source d'entrée (Q_{E}) respectivement dans le plan d'image de sortie (B_{A}) et dans le plan de source de sortie (Q_{A}).

10. Filtre d'énergie électronique selon la revendication 9, caractérisé en ce que des plaques de blindage (38, 39) sont disposées avant la première zone de déviation (12b), entre les zones de déviation (12b, 13b, 14b, 12e) et après la dernière zone de déviation (12e), plaques dont les surfaces se trouvent au moins à peu près à la hauteur des surfaces des pièces polaires (32, 33) et dont les bords (40c, 40d) sont disposés à une faible distance (S) des et parallèlement aux bords (32c, 32d) des pièces polaires.

11. Filtre d'énergie électronique selon la revendication 10, caractérisé en ce que les angles de déviation (Φ), les angles (ε₁, ε₂, ε₃, ε₄) entre la direction du front d'ondes et les bords des pièces polaires (12c, 12d, 13a) et le rapport (R₁/R₂) des rayons de déviation (R₁, R₂) prennent les valeurs suivantes
Φ = 104°
ε₁ = 18,0°
ε₂ = 39,0°
ε₃ = 27,5°
ε₄ = 30,1°
R₂/R₁ = 1
et en ce que la distance (d₁) entre le plan de source d'entrée et le bord d'entrée de la première zone de déviation (12b), les distances (12, 13) entre les zones de déviation, la distance (D) entre les plaques de blindage (38, 39) au niveau du faisceau électronique (11) et la distance (S) entre les bords (40c, 40d) des plaques de blindage et les bords (32c, 32d) des pièces polaires sont choisies comme suit
d₁ = 1,03 R₁
l₁ = 0,92 R₁
l₂ = 2,43 R₁
l₃ = 1,34 R₁
S = 0,14 R₁
D = 0,14 R₁,
R₁ étant sélectionné de manière à ce que la somme d₁ + l₁ égale la distance séparant le plan de source du plan d'image, déterminée par le système de reproduction du microscope électronique.
